Europäisches Patentamt

European Patent Office

Office européen des brevets

(11) Publication number: **0 441 381 A1**

## (12) EUROPEAN PATENT APPLICATION

(21) Application number: **91101700.2**

(22) Date of filing: **07.02.91**

(51) Int. Cl.⁵: **G08B 13/26, H03K 17/955, B60R 25/00, B60R 22/48**

(30) Priority: **08.02.90 JP 29320/90**

(43) Date of publication of application:
**14.08.91 Bulletin 91/33**

(84) Designated Contracting States:
**DE FR GB**

(71) Applicant: **AISIN SEIKI KABUSHIKI KAISHA**
**1, Asahi-machi 2-Chome**
**Kariya City Aichi Pref.(JP)**

(72) Inventor: **Aoki, Kohji**
**505, Osakiyama 1-chome, Midori-ku**
**Nagoya city, Aichi pref.(JP)**
Inventor: **Tatsumi, Teruo**
**3, Minamiyouchi, Higashibata-cho**
**Anjo city, Aichi pref.(JP)**
Inventor: **Kando, Masahiro**
**106-1, Zaimoku-cho**
**Okazaki city, Aichi pref.(JP)**

(74) Representative: **Pellmann, Hans-Bernd,**
**Dipl.-Ing. et al**
**Patentanwaltsbüro**
**Tiedtke-Bühling-Kinne-Grupe-Pellmann-Grams, Bavariaring 4**
**W-8000 München 2(DE)**

(54) **Capacitive occupation detector apparatus.**

(57) A capacitive occupation detector apparatus is comprised of a first electrode having an inner space, a second electrode constituting a capacitor by cooperating the first electrode, and a detecting device for detecting the existence of a person based on the change of capacitance between both electrodes.

Fig. 1

## CAPACITIVE OCCUPATION DETECTOR APPARATUS

### BACKGROUND OF THE INVENTION

The present invention relates to a capacitive occupation detector apparatus.

A conventional capacitive occupation detector apparatus is disclosed in Japanese Patent Publication 62-2276 which was published in 1987 after examination. An outline of the conventional apparatus will be hereinbelow detailed with reference to Figs. 10 and 11.

The conventional apparatus includes a pair of spaced apart upper and lower electrodes 1 and 2 which constitute a capacitor or a condenser. Electrostatic capacity generated between both electrodes 1 and 2 is changed in proportion to the change in the number of electric line of force which is affected by a dielectric 5. As well known, the density of electric lines of force is high between both electrodes 1 and 2, and is higher at a portion adjacent an edge or an outer periphery 1a of the upper electrode 1. By utilizing this phenomena, detection of the number of electric lines of force makes it possible to detect the proximity of the dielectric 5 relative to the capacitor.

However, in the conventional device, the foregoing density is relatively low at remaining portions of the electrode 1. This means that, as shown in Figure 11, the dielectric 5 is not determined to be adjacent the electrode 1 despite the position of the dielectric 5 above the central portion of the electrode 1.

Since an occupant or a driver in a vehicle is regarded as the dielectric in practice, the foregoing drawback is realized since the occupant or driver can't be detected when sitting on the seat in which the capacitor is accommodated as a sensor.

### SUMMARY OF THE INVENTION

It is therefore a primary object of the present invention to provide a capacitive occupation detector apparatus without the aforementioned drawback.

To achieve the objects and in accordance with the purposes of the present invention, a capacitive occupation detector apparatus is comprised of a first electrode including therein an inner space or opening, a second electrode constituting a capacitor by cooperating with the first electrode, and a detection device for detecting the existence of a person based on the change of capacitance between both electrodes.

The foregoing idea or concept enables uniform or even distribution of lines of electric force around the electrode, thereby enabling accurate detection of a person adjacent the electrode.

The foregoing and other objects, features and advantages of the invention will be apparent from the following more particular description of a preferred embodiment of the invention as illustrated in the accompanying drawings.

### BRIEF DESCRIPTION OF THE DRAWINGS

Figure 1 is a perspective view of a seat apparats to which the present invention is applied.

Figure 2 is a perspective view of an upper fabric for the seat apparatus in which a first electrode is accommodated.

Figure 3 is a plan view of the configuration of the first electrode.

Figure 4 is a circuit diagram of a detection means.

Figure 5 is a view showing the approach of a dielectric to the first electrode.

Figure 6 is a graph showing the measured sensitivity under the condition shown in Figure 5.

Figures 7 and 8 show other variations of the first electrode.

Figure 9 is a view showing the lines of electric force between two electrodes.

Figure 10 shows a conventional approach of a dielectric to an electrode; and

Figure 11 is a graph showing the measured sensitivity under the condition shown in Figure 10.

### DETAILED DESCRIPTION OF THE INVENTION

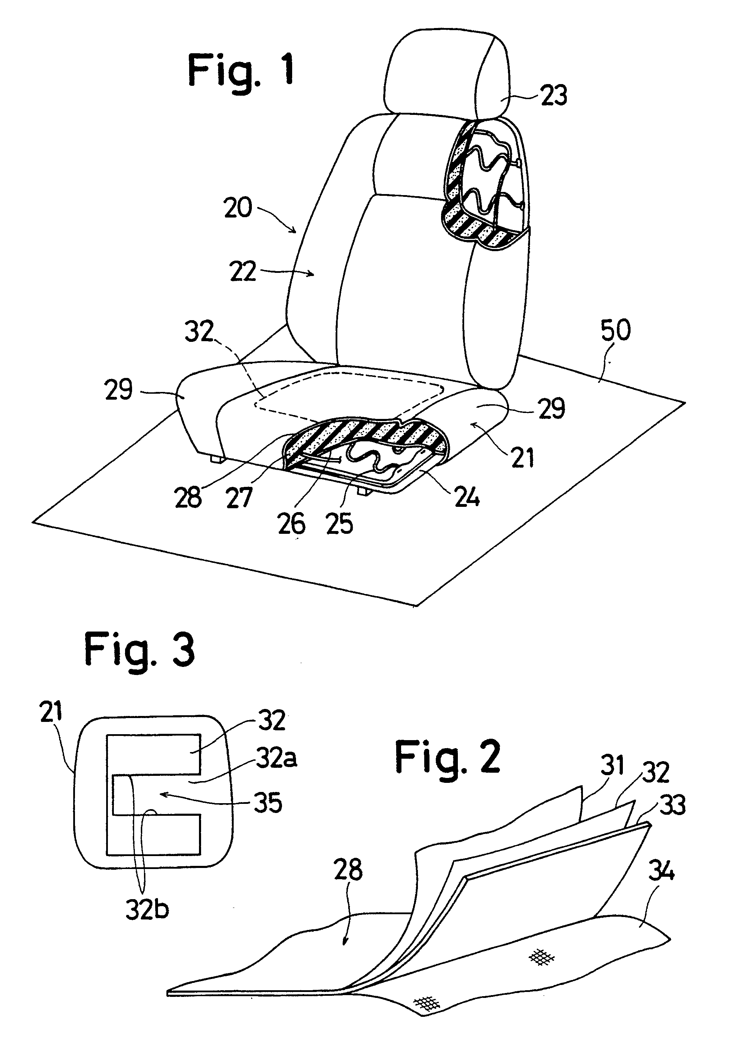

Referring now to Figure 1, a seat apparatus 20, which is to be mounted on a floor of a vehicle body 50, includes a seat-cushion 21, a seat-back 22 and head-rest 23 as is well known. The seat-cushion 21 has a frame 24 secured to the vehicle-body 50, spring means 25 arranged on the frame 24, a pad support 26 mounted on the spring means 25, a cushion pad 27 on the pad support 26 and an upper fabric secured to the frame 24 and covering the cushion pad 27. A pair of side supports 29, which serve to retain the body of an occupant (not shown), are formed at opposite sides of the seat cushion 21 respectively.

As shown in Figure 2, the upper fabric 28 includes an outer layer 31, a detecting electrode 32 in the form of a conductive non-woven fabric, a sponge sheet 33 for increasing stereognosis of the outer layer 31 and a wadding cover 34 which are arranged in layers to be sewn simultaneously. During this sewing operation, the electrode 32 is located at a position between the side supports 29.

In Figure 3, there is shown a plan view of the detecting electrode 32. At a central portion 35 of the electrode 32, there is formed a space 32a thereby configurating a substantial U-shaped electrode 32. Each of the distal ends of this electrode 32 is perpendicular to a lengthwise line of the vehicle body. As a result of the establishment of the space 32a, a pair of opposed edges 32b and 32b are defined thereacross at which lines of electric force have a high density, thereby increasing sensitivity for detecting a human-body at the central portion 35 of the electrode 32. Thus, if a person sits adjacent the central portion 35 between the side supports 29 and 29, the person sitting on the seat apparatus 20 can be easily detected regardless of sitting attitude.

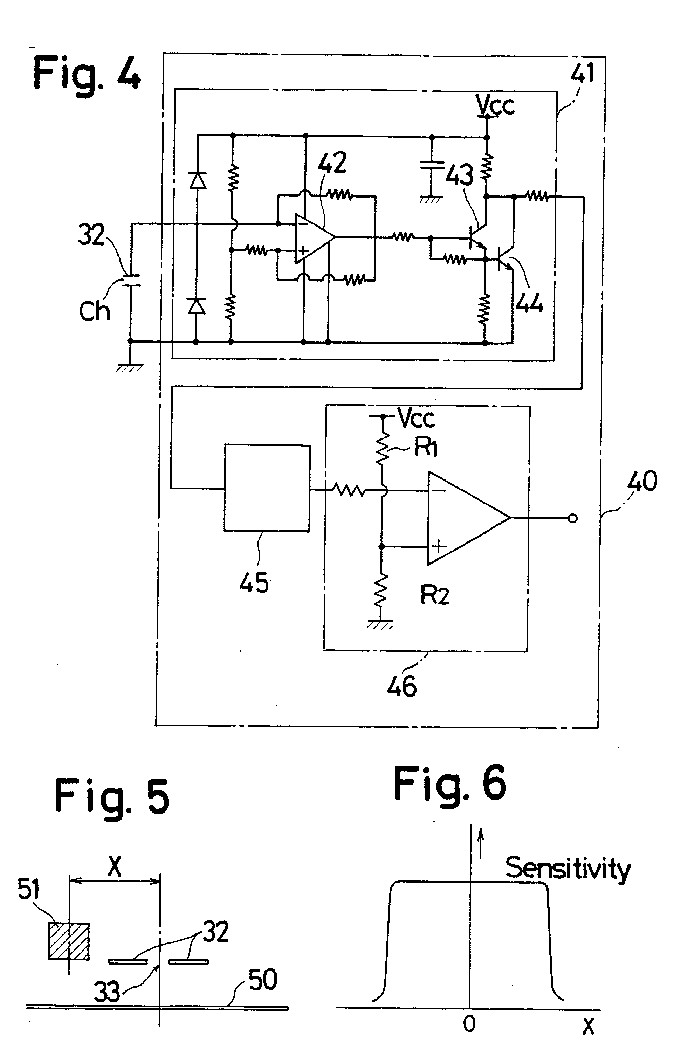

with reference to Figure 4, a detailed description will be made as to how a human body can be detected. A detecting circuit 40 includes a capacitor Ch formed by the detecting electrode 32 and the vehicle-body 50. The capacitor Ch is connected to a pulse generator 41 which is in the form of an unstable multivibrator having an operational amplifier 42 as a main component. The frequency of a signal produced by the pulse generator 41 varies depending on the capacitance of the capacitor Ch. When a person sits on the seat apparatus 20, capacitance of the capacitor Ch becomes large, thereby lowering the frequency of the output signal of the generator 41. On the contrary when no person is on the seat apparatus 20, the capacitance of the capacitor Ch is low, thereby increasing the frequency of the output signal of the generator 41.

The generated pulse signal is amplified by transistors 43 and 44 and the resulting signal, is then inputted to a comparison circuit 46 via a frequency/voltage convertor 45. In the comparison circuit 46, a voltage level derived from the convertor 45 is compared with a reference voltage which is determined by both resistors R1 and R2. As a result of this comparison, a signal is outputted from the circuit 46 which indicates whether or not a person is on the seat apparatus 20.

As apparent from Figures 5 and 6, when a dielectric 51 which can be regarded as a person is moved in parallel with the vehicle-body 50, toward the central portion 35 of the electrode means 32, so long as the dielectric 51 is within a distance X from a line 33 which is perpendicular to the central portion 35, the sensitivity of the dielectric 51 is substantially constant which is observed as the output voltage of convertor 45. In other words, in the vicinity of the electrode means 32, the dielectric 51 can be sensed or detected with substantial sensitivity.

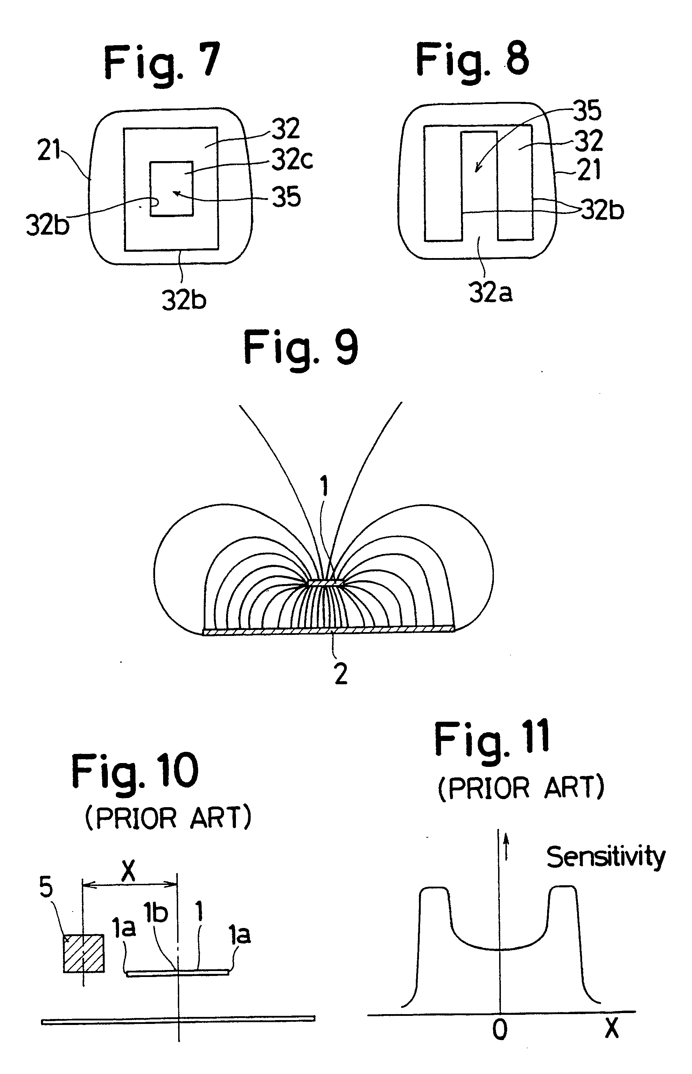

In should be noted that various shapes or configuration of the electrode means 32 can be designed other than the shape shown in Figure 3. For example, as shown in Figure 7, the electrode means 32 can be in the form of a rectangular opening 32c which is in the form of a punched hole. The configuration of the opening 32c can be round, triangular or any other shape. In addition, as shown in Figure 8, a new arrangement can be obtained by rotating the electrode means 32 shown in Figure 3 through 90 degrees. Under this arrangement, both edges 32b, 32b correspond to both legs (not shown) of a person.

As mentioned above, according to the present invention, a substantial uniform distribution of electric line of force can be obtained or established around the electrode means. Since this distribution is extremely sensitive in comparison with that of the conventional device, the ability for detecting a person at any position near the seat is remarkably improved.

While the invention has been particularly shown and described with reference to preferred embodiments thereof, it will be understood by those in the art that the foregoing and other changes in form and details may be made therein without departing from the spirit and scope of the invention.

A capacitive occupation detector apparatus is comprised of a first electrode having an inner space, a second electrode constituting a capacitor by cooperating the first electrode, and a detecting device for detecting the existence of a person based on the change of capacitance between both electrodes.

## Claims

1. A capacitive occupation detector apparatus comprising:

    a first electrode having an inner space therein;

    a second electrode constituting a capacitor by cooperating with the first electrode; and

    detecting circuit means for detecting the presence of a person based on the change of capacitance between said electrodes.

2. A capacitive occupation detector apparatus according to claim 1, wherein the inner space is in the form of a rectangular cutout and the first electrode has a U-shaped configuration.

3. A capacitive occupation detector apparatus according to claim 1, wherein the inner space is in the form of an opening completely surrounded by said first electrode.

4. A capacitive occupant detector apparatus according to claim 1, wherein the first electrode is disposed within a seat apparatus and the second electrode is comprised of a vehicle body.

**Fig. 1**

**Fig. 3**

**Fig. 2**

4

Fig. 4

Fig. 5

Fig. 6

Sensitivity

# Fig. 7

# Fig. 8

# Fig. 9

# Fig. 10
## (PRIOR ART)

# Fig. 11
## (PRIOR ART)

Sensitivity

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | <u>DE - A1 - 2 549 588</u><br>(BOSCH)<br>   * Totality *<br>-- | 1-3 | G 08 B 13/26<br>H 03 K 17/955<br>B 60 R 25/00<br>B 60 R 22/48 |
| A | <u>DE - A1 - 2 716 870</u><br>(HÖFER)<br>   * Totality *<br>-- | 1,4 | |
| Y | <u>DE - A1 - 3 129 612</u><br>(KOHLER)<br>   * Fig. 1; claims 11-16 *<br>-- | 1-4 | |
| A | <u>DE - A1 - 3 213 065</u><br>(SENSORMATIC)<br>   * Claims; fig. 1,2 *<br>-- | 1 | |
| X | <u>US - A - 3 764 861</u><br>(ORRIS)<br>   * Totality *<br>-- | 1-2,4 | |
| Y | <u>US - A - 3 863 209</u><br>(HOLLINS)<br>   * Column 3, line 23-28,<br>    line 35-58; fig. 1 *<br>-- | 1-4 | **TECHNICAL FIELDS SEARCHED (Int. Cl.5)**<br><br>G 08 B 13/00<br>H 03 K 17/00<br>B 60 R 22/00<br>B 60 R 25/00 |
| Y | <u>US - A - 3 874 474</u><br>(QUANTZ)<br>   * Totality *<br>-- | 1-4 | |
| Y | <u>US - A - 3 943 376</u><br>(LONG)<br>   * Totality *<br>-- | 1-4 | |
| Y | <u>US - A - 4 055 735</u><br>(EACHUS et al.)<br>   * Fig. 3,5; abstract *<br>---- | 1-3 | |

The present search report has been drawn up for all claims

| Place of search | Date of completion of the search | Examiner |
|---|---|---|
| VIENNA | 18-04-1991 | BAUMANN |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P0401)